# EUROPEAN PATENT SPECIFICATION

(11) **EP 0 644 409 B1**
(45) Date of publication and mention of the grant of the patent: **29.08.2001**
(21) Application number: 94306773.6
(22) Date of filing: 15.09.1994
(51) Int. Cl.: G01K 1/02, G01K 7/00

(54) **A method of remotely measuring process data**
Verfahren zur Fernmessung von Prozessmesswerten
Methode pour mesurer à distance des données d'un processus

(30) Priority: 20.09.1993 US 123664
(43) Date of publication of application: 22.03.1995
(73) Proprietor: NCR International, Inc., Dayton, Ohio 45479 (US); HYUNDAI ELECTRONICS AMERICA, Milpitas, California 95035 (US); Symbios, Inc., Fort Collins, Colorado 80525 (US)
(72) Inventor: Yakura, James P., Colorado Springs, CO 80907 (US); Cole, Richard K., Woodland Park, CO 80866 (US); Von Thun, Matthew S., Colorado Springs, CO 80917 (US); Hass, Crystal J., Colorado Springs, CO 80906 (US); Allman, Derryl D. J., Colorado Springs, CO 80920 (US)
(74) Representative: Gill, David Alan

(56) References cited:
- EP-A- 0 261 353
- EP-A- 0 395 188
- EP-A- 0 406 751
- WO-A-86/01595
- WO-A-91/07736
- MACHINE DESIGN, vol.60, no.11, 19 May 1988, CLEVELAND US pages 149 - 173 ANONYMOUS 'SENSORS AND TRANSDUCERS'

## Description

The present invention relates to a method of remotely sensing temperature conditions at the location of silicon wafers undergoing a process.

One measurement method in current use involves an optical measurement which measures the black body radiation spectrum or a portion of it which is a function of temperature. This measurement is highly dependent upon the surface conditions of the substrate being measured and is therefore difficult to make.

Another measurement method involves the use of a thermocouple. This method is also difficult to carry out because it requires good contact with the wafer for fast and accurate measurements.

EP-A-0406751 discloses an apparatus for sensing process conditions during a process in which a plurality of elements are fabricated and employing a monitor element for assisting in sensing the process conditions and WO-A-8601595 discloses a thermometer arrangement including an inductor structure serving to provide for a contactless temperature measuring arrangement.

It is an object of the present invention to provide a method of measuring temperature conditions of silicon wafers being processed, which overcomes the aforementioned difficulties.

According to the present invention there is provided a method of monitoring temperature conditions of a plurality of silicon wafers during a silicon wafer fabrication process, characterized by the steps of introducing a silicon-wafer-monitor element similar in material and shape to the said silicon wafers into the process in addition to the said silicon wafers and having electrical characteristics determined by its temperature, inductively coupling the said silicon-wafer-monitor element to a primary coil forming part of a primary inductor structure while the said silicon wafers and the said silicon-wafer-monitor element are exposed to the said processing conditions, the primary inductor structure further comprising a current source and a sensor connected to the said primary coil so as to inductively couple eddy currents in the silicon-wafer-monitor element, sensing changes in an electrical signal in the primary coil with the sensor, the changes in the signal being induced by variations of the eddy currents in the silicon-wafer-monitor element, and converting the sensed changes to a temperature value.

It will be appreciated that the impedance of the silicon wafer monitor element can be determined by changes in current amplitude and phase within the primary coil.

The examples shown in Fig. 1-4 are not covered by the claims but provide examples which are useful for understanding the invention.
Fig. 1 shows a schematic approximation of a secondary current loop comprising an RC circuit on a wafer which is inductively coupled to a primary coil of a transformer and sensing structure;
Fig. 2 is a diagrammatic view of a closed secondary current loop which has been deposited on a substrate;
Fig. 3 is a diagrammatic view of a wafer located in operative relation to a transformer and sensing structure; and
Fig. 4 is a diagrammatic view of a spiral segment with connecting strap which has been deposited on a substrate;

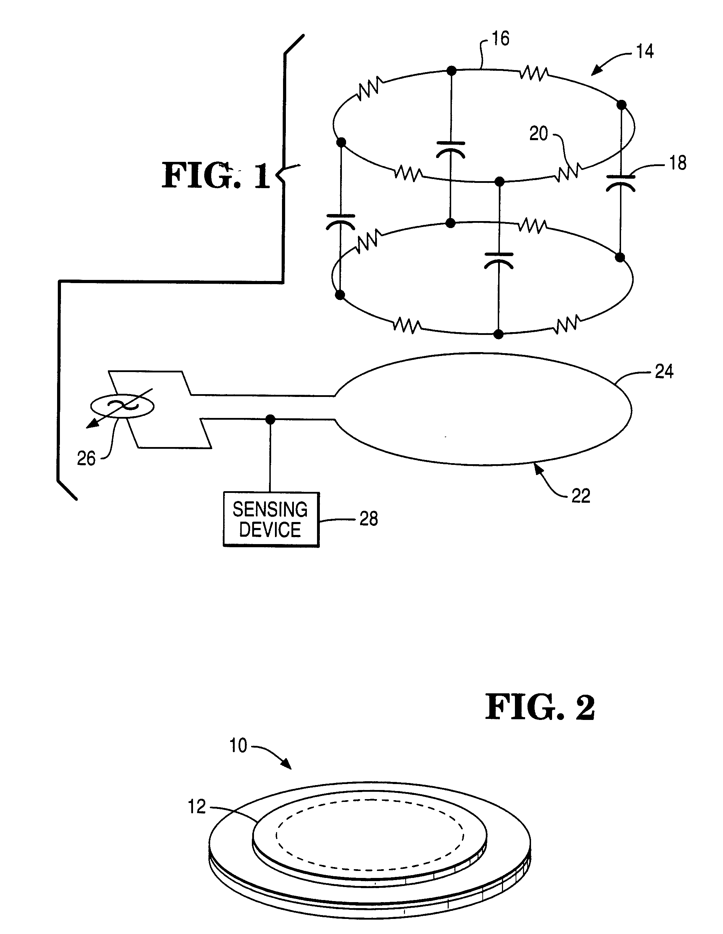

The monitor wafer 10 (Fig. 2), which does not form an embodiment of the invention, is prepared for use by forming a structure 12 on its surface, which structure subsequently acts as the secondary current loop of a transformer. This structure may be considered to be a circular transmission line whose characteristic capacitance and resistive impedances vary in a predetermined fashion with ambient conditions such as temperature. For a given structure and set of ambient conditions, this secondary current loop may be expected to have a characteristic resonant frequency. In Fig. 1, a representation 14 of the secondary current loop is shown as comprised of a circuit 16 including a plurality of capacitances 18 and a plurality of resistances 20. The circuit 16 is shown as located in operative relationship with a representation of a transformer structure 22 which includes a primary coil 24, a current source 26 and a sensing device 28 which is capable of sensing electrical measurements from the primary coil 24.

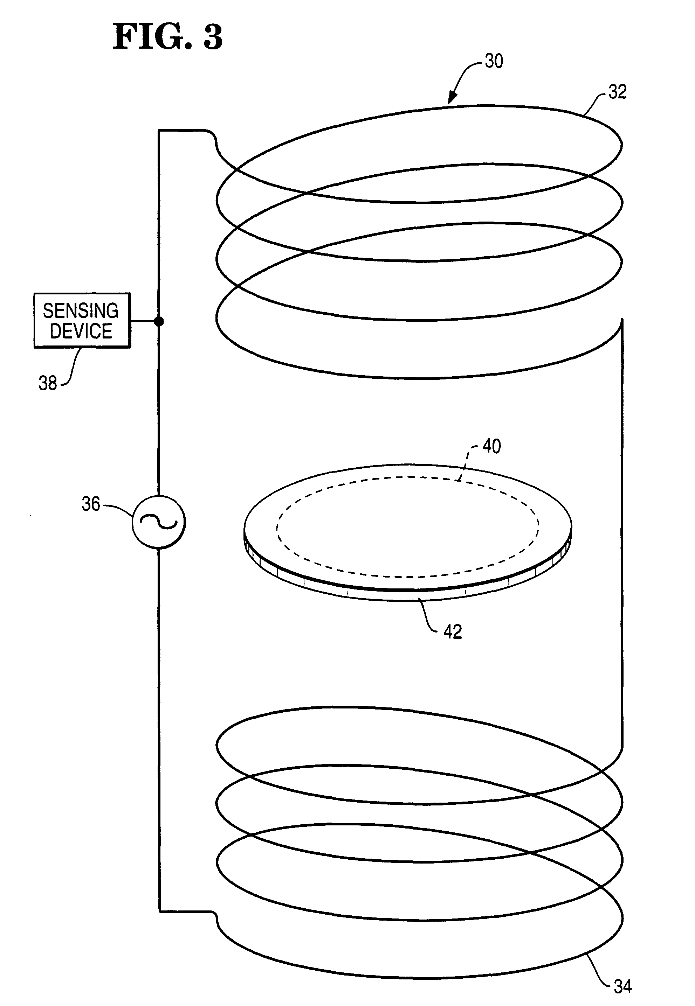

A similar arrangement, which does also not form an embodiment of the invention, is shown in Fig. 3, in which a transformer structure 30 includes two coupled primary coils 32, 34, a current source 36 and a sensing device 38. A secondary coil 40 forms part of a monitor wafer 42 which is positioned between the primary coils 32, 34.

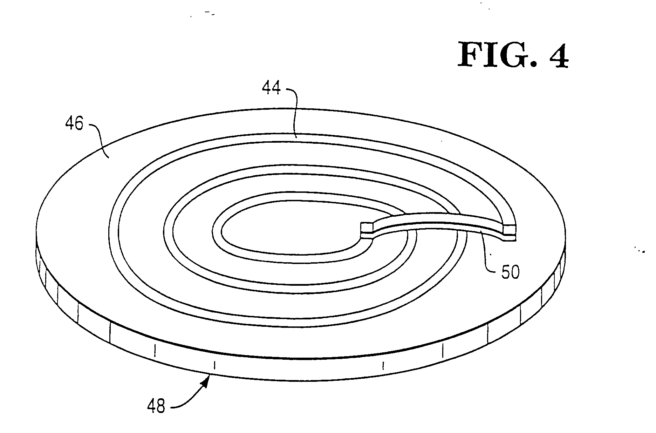

The secondary current loop need not be a closed continuous current loop structure shown in Fig. 2. Other appropriate configuration can be employed, if desired. One such configuration, which does also not form an embodiment of the invention, is shown in Fig. 4, in which a portion of a spiral 44 is located on a surface 46 of a wafer 48. The ends of the spiral segment are joined by a conductive, resistive or semiconductive strap 50 which is insulated by a suitable insulating layer (not shown) from the portions of the spiral 44 over which it passes.

In an embodiment of the invention is a silicon wafer without a loop structure thereon employed as a monitor wafer. Locating such a wafer in operative relation with respect to the primary coil of a transformer structure and the application of power to the primary coil will induce eddy currents in the wafer, which in turn will affect the electrical measurements taken from the transformer structure by a sensing device. These measurements may then be used, after proper calibration, to determine desired data, such as temperature, relating to the monitor wafer. Since the monitor wafer is made of the same material and has the same configuration as the wafers actually being processed, this same temperature or other value is also applicable to the wafers being processed.

The present invention may find use in a number of different applications. One such application is in the periodic determination of temperature of a group or batch of silicon wafers which are being processed in the course of manufacture of semiconductor devices. In such a process, it is desirable to avoid actual contact with the silicon wafers in order to avoid possible contamination. Accordingly, a monitor wafer, being made from the same material and having the same configuration as the wafers being processed, can be included in the batch of wafers being processed, and its temperature, which will be essentially identical to the temperature of the other wafers in the batch, can be ascertained. This can be done without actual physical contact with the monitor wafer, as shown in Fig.3, by causing a monitor wafer to come into operative relation with the primary coils 32, 34 of a transformer structure 30, and detecting by use of the sensing device 38 the resulting change in electrical characteristics. By appropriate calibration, the change in electrical characteristics can be converted to indicate the temperature of the monitor wafer, which will be essentially identical to the temperature of the actual wafers being processed and a change in internal eddy currents, when exposed to the field from the primary coils of the transformer structure, is relied upon to produce a change in the current in the primary coils which can be sensed by a sensing device and converted to a temperature value.

## Claims

1. A method of monitoring temperature conditions of a plurality of silicon wafers during a silicon wafer fabrication process, characterized by the steps of introducing a silicon-wafer-monitor element similar in material and shape to the said silicon wafers into the process in addition to the said silicon wafers and having electrical characteristics determined by its temperature, inductively coupling the said silicon-wafer-monitor element to a primary coil (32, 34) forming part of a primary inductor structure (30) while the said silicon wafers and the said silicon-wafer-monitor element are exposed to the said processing conditions, the primary inductor structure further comprising a current source (36) and a sensor (38) connected to the said primary coil (32, 34) so as to inductively couple eddy currents in the silicon-wafer-monitor element, sensing changes in an electrical signal in the primary coil (32, 34) with the sensor (38), the changes in the signal being induced by variations of the eddy currents in the silicon-wafer-monitor element, and converting the sensed changes to a temperature value.

2. A method according to Claim 1, **characterized in that** the said electrical signal comprises current amplitude and the impedance of the silicon-wafer-monitor element is determined by changes in the current amplitude and phase within said primary coil (32, 34).

## Patentansprüche

1. Verfahren zum Überwachen von Temperaturbedingungen einer Vielzahl von Siliciumwafern während eines Siliciumwafer-Herstellungsvorgangs, gekennzeichnet durch die Schritte, ein Siliciumwafer-Überwachungselement, das hinsichtlich Material und Form ähnlich den Siliciumwafern ist, zusätzlich zu den genannten Siliciumwafern in den Vorgang einzubringen, das durch seine Temperatur bestimmte elektrische Charakteristiken hat, das genannte Siliciumwafer-Überwachungselement an eine Primärspule (32, 34) induktiv zu koppeln, die einen Teil einer primären Induktionsstruktur (30) bildet, während die genannten Siliciumwafer und das genannte Siliciumwafer-Überwachungselement den genannten Verarbeitungsbedingungen ausgesetzt sind, wobei die primäre Induktionsstruktur weiter eine Stromquelle (36) und einen Sensor (38) angeschlossen an die genannte Primärspule (32, 34) aufweist, um so Wirbelströme in dem Siliciumwafer-Überwachungselement induktiv zu koppeln, Änderungen in einem elektrischen Signal in der Primärspule (32, 34) mit dem Sensor (38) zu ermitteln, wobei die Änderungen in dem Signal durch Variationen der Wirbelströme in dem Siliciumwafer-Überwachungselement hervorgerufen werden, und die ermittelten Änderungen in einen Temperaturwert umzuwandeln.

2. Verfahren nach Anspruch 1, **dadurch gekennzeichnet**, daß das genannte elektrische Signal eine Stromamplitude aufweist und die Impedanz des Siliciumwafer-Überwachungselements durch die Änderungen in der Stromamplitude und Phase innerhalb der genannten Primärspule (32, 34) bestimmt wird.

## Revendications

1. Procédé de contrôle de conditions de température d'une pluralité de tranches de silicium durant un processus de fabrication de tranches de silicium, caractérisé par les étapes d'introduction d'un élément de contrôle de tranches de silicium semblable en matière et en forme auxdites tranches de silicium dans le processus en plus desdites tranches de silicium et ayant des caractéristiques électriques déterminées par sa température, couplage inductif dudit élément de contrôle de tranches de silicium à une bobine primaire (32, 34) faisant partie d'une structure inductrice primaire (30) tandis que lesdites tranches de silicium et ledit élément de contrôle de tranches de silicium sont exposés auxdites conditions de traitement, la structure inductrice primaire comprenant en outre une source de courant (36) et un capteur (38) connectés à ladite bobine primaire (32, 34) de manière à coupler inductivement des courants de Foucault dans l'élément de contrôle de tranches de silicium, détection de changements d'un signal électrique dans la bobine primaire (32, 34) avec le capteur (38), les changements du signal étant induits par des variations des courants de Foucault dans l'élément de contrôle de tranches de silicium, et conversion des changements détectés en une valeur de température.

2. Procédé conformément à la revendication 1, **caractérisé en ce que** ledit signal électrique comprend une amplitude de courant et l'impédance de l'élément de contrôle de tranches de silicium est déterminée par des changements de l'amplitude et de la phase du courant au sein de ladite bobine primaire (32, 34).
